Europäisches Patentamt

European Patent Office

Office européen des brevets

(11) Publication number: **0 210 397**
**A1**

## EUROPEAN PATENT APPLICATION

(21) Application number: 86108085.1

(22) Date of filing: 13.06.86

(51) Int. Cl.⁴ **H01L 23/52** , H01L 27/02

(30) Priority: 15.07.85 US 755123

(43) Date of publication of application:
04.02.87 Bulletin 87/06

(84) Designated Contracting States:
DE FR GB

(71) Applicant: International Business Machines
Corporation
Old Orchard Road
Armonk, N.Y. 10504(US)

(72) Inventor: Aipperspach, Anthony Gus
2706 24th Street N.W.
Rochester Minnesota 55901(US)
Inventor: Fitzgerald, Joseph Michael
5506 26th Avenue N.W. Apt. B
Rochester Minnesota 55901(US)

(74) Representative: Vekemans, André
Compagnie IBM France Département de
Propriété Intellectuelle
F-06610 La Gaude(FR)

(54) LSI circuits adaptable for custom design methods.

(57) A standardized cell layout for LSI circuits having a first and second metal overlay pattern (16,18; 260-265) above a predetermined generalized logic circuit pattern, where the first metal overlay includes a generally parallel set of conductors having conductive contact with underlying circuits at a plurality of possible contact points, and the second metal overlay is insulated from the first metal overlay, the second metal overlay having a plurality of orthogonal conductors relative to the first metal overlay, to permit selective laser cutting of first metal conductor segments at positions intermediate second metal conductors, and to permit laser welding of first and second metal conductors at respective intersections of same.

Fig. 5A

# LSI CIRCUITS ADAPTABLE FOR CUSTOM DESIGN METHODS

Technical Fields

This invention relates to large-scale integration (LSI) circuits using field-effect transistors (FET) as the circuit technology, and more particularly to an LSI circuit of generalized design which is adaptable to custom design techniques, and a method for converting a generalized LSI circuit into special function logic circuits.

Background of the Invention

The construction of LSI circuits is generally known in the art, using various forms of material technology and manufacturing processing steps. This technology typically utilizes a single chip as a base member, and, through the successive application of masking, etching and deposition steps, multiple layers of conductive and semiconductive material are applied with great precision to create a large number of internal cells and a smaller number of peripheral or input-output cells. All of the cells are arranged in predetermined locations and embody predetermined logic functional combinations. Special input-output cells are typically aligned along the peripheral edges of the chip and serve to conduct signals into and out of the various functional logical circuits which are prearranged in the cells arrayed across the chip. Because the internal cells are neatly arranged in rows and columns it is possible to achieve a very high packing density of logic circuits within an LSI chip. Intercell spacing provides room for the orderly deposition of conductive members so as to provide conductive signal paths between various cells, with such conductive paths usually being provided in the X and Y orthogonal directions.

The high packing density of LSI circuits, and the fact that a large number of logic cells is present on a single LSI chip, increase the difficulty of designing customized logic functions utilizing multiple combinations of logic elements through the custom interconnection of a plurality of cells. With this difficulty in mind, a "masterslice" concept has been developed for bipolar devices, wherein all of the cells can be processed exactly alike up to a certain point in the manufacturing process, and these partially manufactured chips can be stockpiled for subsequent addition of customizing manufacturing steps. This is a pratical solution to the problem of customizing LSI chips when the personalization of such chips requires only a few additional process steps beyond the steps required for stockpiling, where the personalization steps can be accomplished in a relatively short turnaround time. This leads to the potential of utilizing LSI circuit technology in custom logic design situations, requiring less total manufacturing time than would otherwise be required if a specially designed LSI circuit chip was manufactured from an initial process.

One customizing approach in the design of LSI circuits is described in U.S. Patent No. 3,983,619, in which an LSI chip is made from an array of unit cells. All of the unit cells on the chip perform the same logical functions, that is, AND, NAND, or OR. The unit cells are simple depletion-load circuits, and no provision is made for powering to multiple power levels in the unit cells. Another approach is described in U.S. Patent No. 4,141,662, in which an LSI chip contains a fixed number of different logic functions.

Still another approach is described in European Patent Application No E.P. 0113 828 , Appl. No 83111224.8 wherein a plurality of cells are developed on a chip, each of the cells being capable of interconnection for the creation of approximately twenty different logic functions at any of several different power levels. In this approach, multiple cells can be interconnected to form macro functions by successive application of process steps beyond an initial series of process manufacturing steps. A multi-level chip is first created utilizing etching and masking techniques. In particular, the first six mask levels are common for all part numbers, and all of the process steps associated with the first six mask levels can be completed to enable the chip to be stockpiled. Subsequently, when custom circuit designs are desired, the chip can be personalized by adding a further four mask levels for a given logic circuit design. This technique utilizes a single layer of conductors for personalizing the intercircuit wiring in any cell, so that a further conductor layer may be used to provide intercell wiring anywhere on the chip.

Summary of the Invention

The present invention decreases even further the turnaround time between circuit design and completed chip, by depositing the final four mask levels of every masterslice in a single pattern designed to allow later personalization of individual chips by selectively cutting and welding the already formed layers at designated locations with a laser or similar tool. The invention is especially useful in applications requiring very low design time but relatively low volumes, such as prototyping and customized products. A further advantages of the invention is compatibility with conventional technology so that a design implemented according to the present invention can later be ported directly to a conventional technology such as that of EPA 0113.828.

Each cell is capable of multiple logic functions at any of several power levels, and all cells are developed through full ten mask levels in generalized form, thereby requiring no further process masking, etching or deposition steps. Two conductive layers are created in generally orthogonal grid patterns, a first and lower conductive metal grid pattern making all possible intracell connections, and a second higher conductive metal grid orthogonally arranged and spaced from the first metal layer by an insulator, and overlaying all cells on the chip. The grid of first and second level metal layers are arranged so as to vertically position, in all cases, a first level conductor in an intermediate space between second level conductors, so that at least one vertical plane segment can be identified for each first level conductor, which plane does not pass through any second level conductor. At the same time, at least a segment of all first level conductors are positioned directly beneath corresponding second level conductors, separated only by the insulating layer. According to this construction it is therefore possible to utilize laser cutting and welding tools for making all required interconnections between first and second level conductors, as well as to selectively cut first and second level metal conductors at appropriate points in order to form a complete interconnected grid of conductors for any of a plurality of logic functions.

The method of forming such circuit interconnections forms an important part of the present invention, and includes the selective steps of laser cutting and welding to accomplish this purpose. The step of laser cutting includes either or both cutting the outer metal conductor and cutting through the intermediate insulator to cut the lower metal conductor, at a location intermediate the outer metal conductors.

Brief Description of the Drawings

Fig. 1 shows a top view representation of a plurality of lower layers of one standard cell of a multi-cell chip;

Fig. 2 shows a schematic representation of the cell of Fig.1;

Fig. 3 shows a top view representation of a standard first metal overlay for a standard cell;

Fig. 4 shows a top view representation of a second metal overlay for a standard cell;

Fig. 5A shows a top view composite of first and second metal layers;

Fig. 5B shows a top view composite of first and second metal layers after personalization steps;

Fig. 6 shows a diagram of the logic circuit formed as a result of the steps illustrated in Fig. 5A and 5B;

Fig. 7 shows a top view representation of a plurality of underlayers of three standard cells;

Fig. 8 shows a first metal overlay for the cells shown in Fig. 7;

Fig. 9 shows a second metal overlay for the cells shown in Fig. 7.

Fig. 10 shows the first metal cuts for personalization of the cells of Figs. 7-9; and

Fig. 11 shows a schematic representation of the personalized circuit of Figs. 7-10.

Description of a Preferred Embodiment

Reference should be made to EPA 0113.828 which shows, among other things, an overall layout of a masterslice chip having a plurality of cells therein, and describes the manufacturing process steps for constructing such a masterslice chip.

A masterslice chip, as defined in the above-referenced EPA 0113.828 contains about 2,500 internal cells which are defined as "standard" cells insofar as they embody a consistent and repeatable construction during at least the initial steps of the manufacturing process. Subsequent steps in the manufacturing process enable the standard cells to become personalized into specific logic circuits, to perform various logic functions, either within individual standard cells or in contiguous groups of standard cells and adjacent cell locations.

The foregoing EPA 0113.828 describes a process of constructing a chip through sequential steps of deposition, etching and related processes which are known in this technology. These processes lead to the construction of a multi-level, patterned distribution of conductors, semi-conductors and insulators, associated with each standard cell, the patterns being repeated over the surface of the chip for as many standard cells as are contained on the chip. The present invention departs from the teachings of the foregoing specification in the techniques used for developing and constructing first and second level metal overlay patterns, and in the techniques utilized to interconnect the first and second level metal overlay patterns to one another and to respective conductive vias in the underlayers. In the present invention, the first and second level metal layer patterns are used to personalize a standard cell or cells, according to a process which may be applied after the entire chip has been constructed with all of its layers, including the first and second level metal layers. The unique pattern layout selected for the first and second metal layers, together with the utilization of laser technology, enables this personalization to be accomplished after all of the manufacturing steps have been completed with respect to a plurality of standard cells on a chip.

An article in the February 1984 edition of VLSI Design Magazine, entitled "Designing a Laser-Personalized Gate Array", discloses a technique for laser cutting of a single metal level, initially formed from an X-Y array of conductor segments, wherein the laser cutting process involves selectively cutting away X and/or Y coordinate segments in order to develop the necessary conductive paths for the creation of a CMOS gate array. In this respect, the article describes a personalized gate array in which one layer is personalized. By contrast, the present invention discloses a technique for personalizing standard cells through personalizing two metal layers, which personalization becomes possible through the novel layout of the first and second metal levels. The present invention also contemplates personalization through selectively cutting either or both first and second metal levels, and/or selectively laser welding first and second metal levels together.

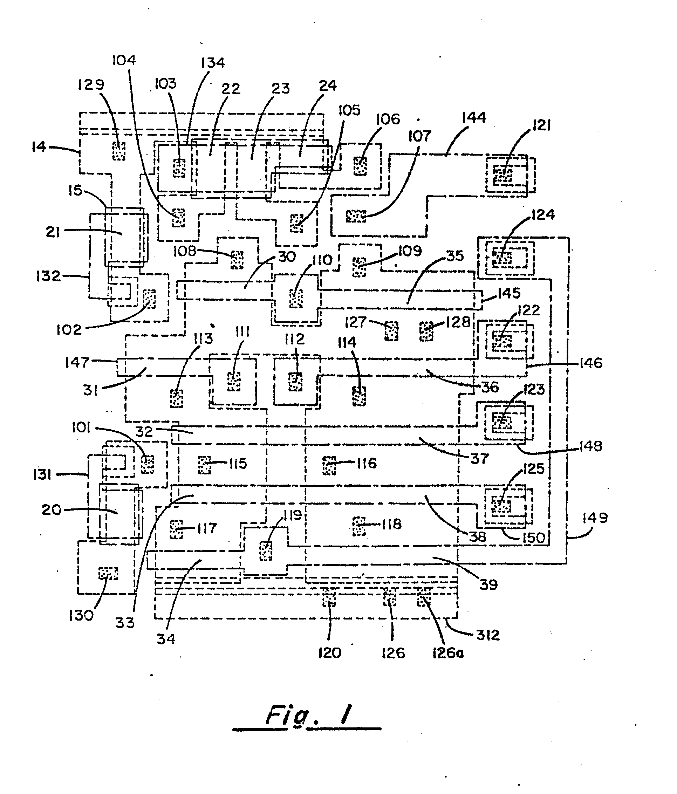

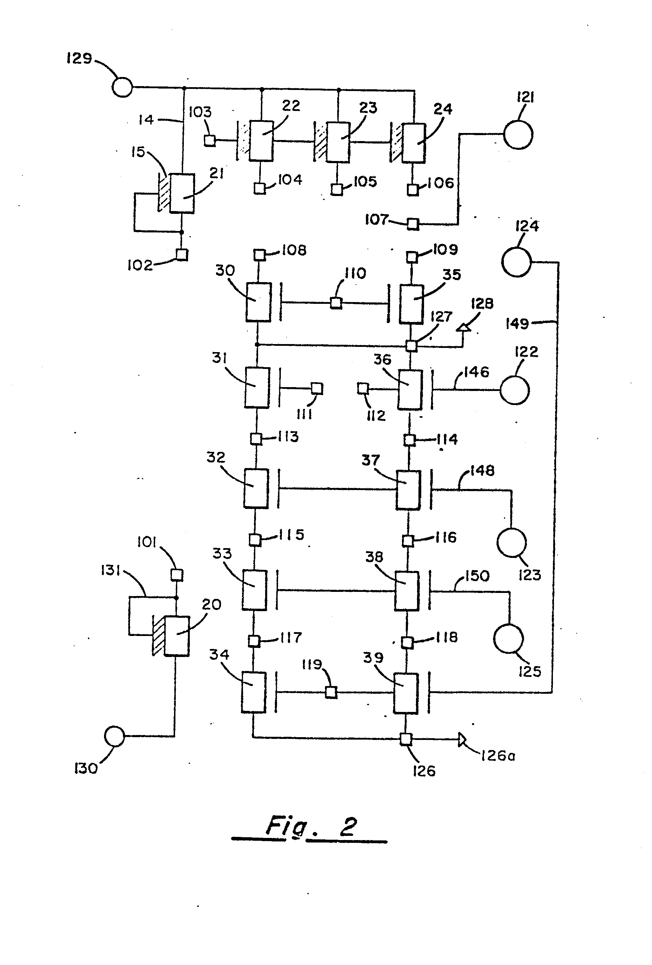

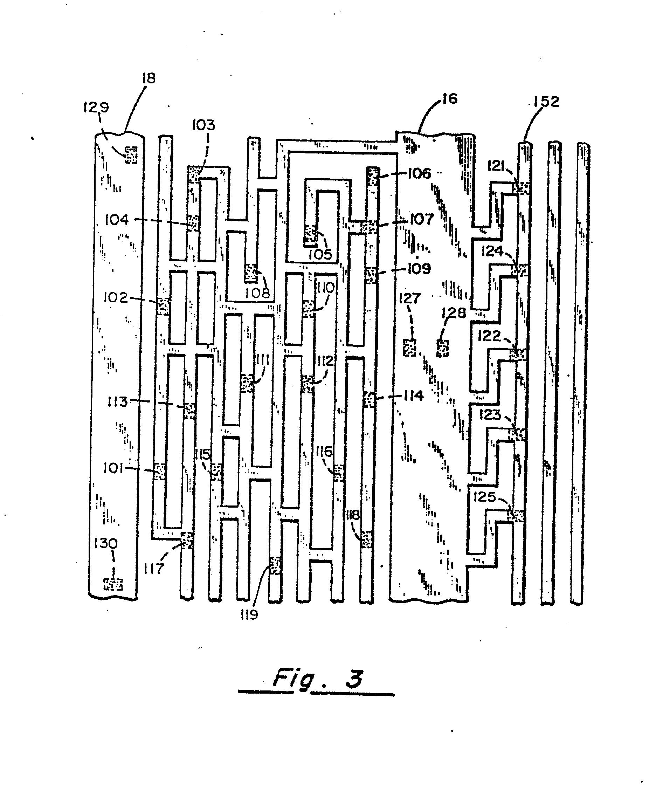

The invention contemplates the initial construction of a multi-level chip having thereon all of the semiconductor components and underlayer conductor segments required for intracell connections. In this respect, Fig. 1 illustrates a representation of a standard cell constructed through a partial manufacturing process. To achieve this level of manufacture, a raw silicon chip is first coated with oxide and nitride layers, and a photoresist mask is used to etch away portions of the nitride, to form what is called the RX diffusion layer. One portion of this diffusion layer shown in Fig. 1 is shown in geometric segment 14, and which is identified as conductor 14 on the schematic diagram of Fig. 2. The oxide layer is then regrown to a greater thickness where it is not covered by the nitride, and enough of the nitride and oxide layers are then removed to expose the silicon in selected regions, and a thin oxide layer is then regrown. A photoresist mask is used to mask everything except the channels of the load devices, and arsenic ions are implanted to convert some of these channels to depletion-mode devices (DFET). An example of one of these channels is identified in Fig. 1 at 15, and is symbolicly illustrated in Fig. 2, as a channel section of DFET load transistor 21. Next, a mask is applied to define buried-contact areas (BCA), to form conductive vias between the RX diffusion layer and subsequent layers. Examples of these vias on Fig. 1 are represented as small rectangles 101-130, and are similarly identified on Fig. 2 and Fig. 3. A polysilicon ohmic conductive layer is next deposited, and another oxide layer is formed above it. These two layers are etched to the mask to define the FET gate electrodes (P1 layer). An FET exists wherever a P1 conductor crosses an RX diffusion layer. An example of an FET formed in this manner is shown in Fig. 1 as segment 131 or segment 132, which forms a part of transistor 20 or transistor 21 and also serves as an internal via, connecting to cell via 101 or via 102. Arsenic is implanted through the thin oxide layer described above, around the gates in the FET channels, to provide N+ doped source and drain electrodes for the FETs, and an oxide layer is then deposited over the chip, using a mask C1 to define vias etched through the oxide for subsequent connection between the first metal layer (M1) and various underlayers. A mask C2 may also be used at this same layer to define vias etched more deeply around the chip edges, extending all the way to the substrate, for purposes not related to the invention. To this point, the manufacturing process steps are identical to those described in EPA 0113.828 resulting in the accumulation of multiple layers which are represented in Fig. 1.

At this stage in the process of manufacture, depletion-type transistors (DFET) are formed at locations 20, 21, 22, 23 and 24, and serve as load transistors. Enhancement-type transistors (EFET) are formed at locations 30-39. Transistors 22, 23 and 24 are load transistors available for delivering multiple power levels to the standard cell. Logic transistors 30, 31, 32 . . . 39 are formed at correspondingly identified locations on Fig. 1. and cell contact points or vias 101, 102, 103 . . . 130 are formed where shown on Fig. 1. Conductive segments 144, 145 . . . 150 are formed to interconnect various components and vias throughout the standard cell. The logic input-output (I/O) connections to the standard cells are formed at vias 121 -125, and the power and grounding connections to the standard cell are formed at vias 126a, 128, 129 and 130.

Fig. 2 shows a schematic representation of the standard cell of Fig. 1, illustrating the various conductors and transistors which are formed as a result of the process steps described hereinabove. The vias and conductive segments, as well as the transistors, are similarly numbered on Figs. 1 and 2, and the schematic diagram of Fig. 2 is generally laid out to conform to the physical layout of the circuit elements shown in Fig. 1. Fig. 2 therefore represents a standard cell schematic diagram, prior to any of the personalization steps which are hereinafter described. These personalization steps have to do with the process of laser cutting and/or laser welding of the first and second metal layers M1 and M2.

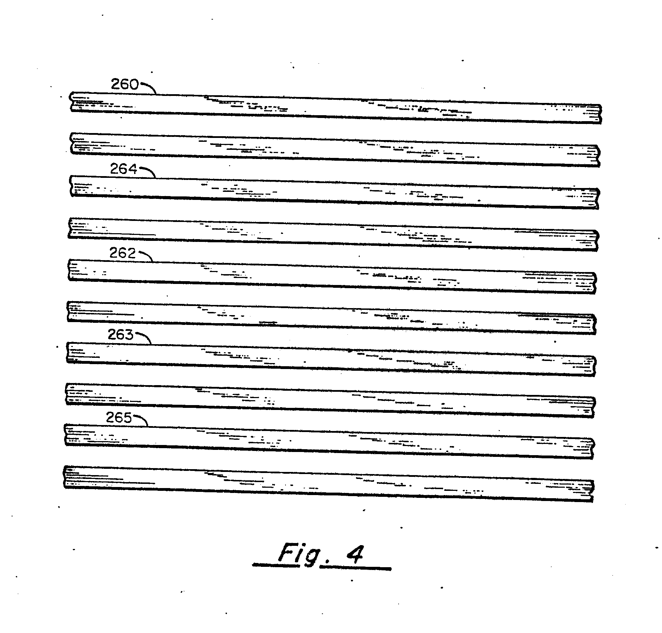

A first metal layer M1 is shown in Fig. 3. This first metal layer is deposited over the substrate shown on Fig. 1, and all other similar substrates on the chip, and the pattern shown in Fig. 3 is a standardized pattern, before personalization. The M1 layer of Fig. 3 contains a conductive segment 16 which will later form the ground connections to the standard cell, and a conductive segment 18 which will later form the power connections to the standard cell. After application of a suitable insulating layer, the second level metal layer M2, a portion of which is shown on Fig. 4, is overlaid over the M1 layer of Fig. 3. The second metal layer comprises a plurality of parallel conductor segments, extending accross the entire standard cell and beyond. The illustrations of Figs. 3 and 4 show the respective first and second level metal layers in relation to a single standard cell. However, it is contemplated that the first metal layer of Fig. 3 is repeatably extended across the entire chip, as is the second metal layer of Fig. 4. Therefore, there is a first and second level metal conductor pattern over the entire face of the chip, which is susceptible to further personalizing manufacturing steps. After these layers have been applied the manufacturing process steps for the entire chip are essentially complete, to provide a chip in standard cell form. The subsequent steps to be described hereinafter may be applied to one or more of the standard cells in the chip in order to personalize the standard cell according to design requirements.

Fig. 3 also illustrates in dotted outline form the locations of vias 101 -130, which are built-up conductors extending vertically from lower cell layers to electrically contact the first metal layer M1. Fig. 3 illustrates 30 electrical contact points between the M1 layer and various substrate layers. These contact points serve to develop the electrical continuity between various semiconductors, and between the semiconductors and input-output terminals, and between power connections and semiconductors. Fig. 3 therefore shows a generalized pattern of contact points and M1 conductors, making all possible electrical connections at the M1 layer. Subsequent process steps will personalize this generalized conductive pattern, to provide only those conductor connections which are necessary to a specific circuit function.

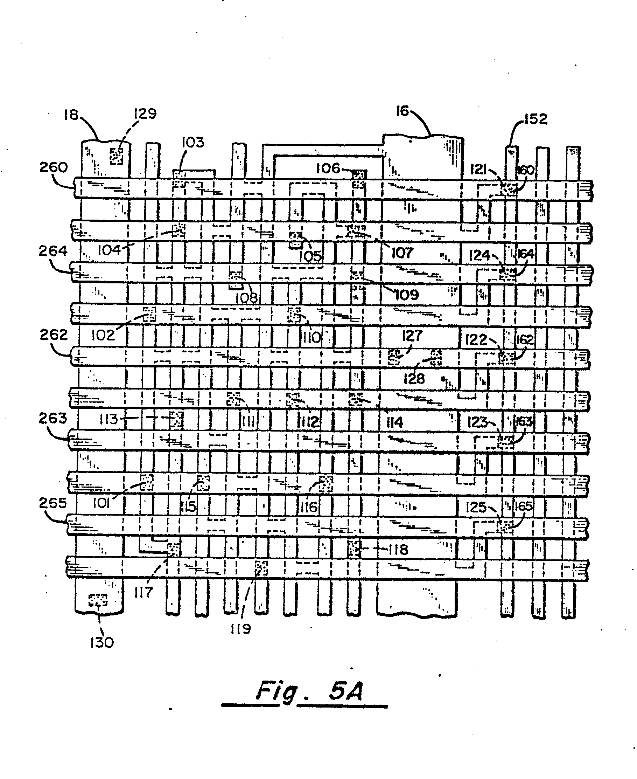

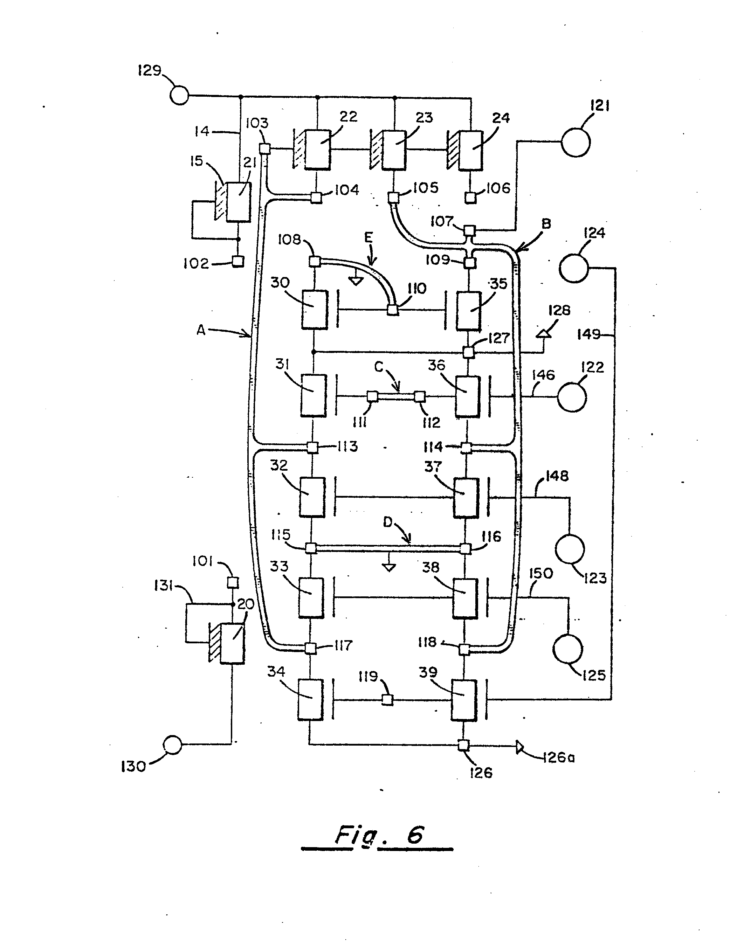

Fig. 5A shows an overlay view of the conductor pattern of Fig. 3 with the overlay conductive pattern of Fig. 4, the two conductor patterns being separated by an insulating layer. None of the parallel horizontal conductive segments of Fig. 4 are electrically connected to the generally vertical conductive pattern of Fig. 3, in the overlay view of Fig. 5A. Fig. 5A therefore shows a generalized horizontal and vertical conductor pattern which is ready for subsequent personalization steps. After the M1 and M2 layers are overlaid on the plurality of lower layers forming a standard cell; i.e. after the M1 and M2 layers of Fig. 5A are overlaid on the semiconductor pattern of Fig. 1; the manufacturing process steps for one standard cell are complete. Assuming the manufacturing process steps are repeated for all of the standard cells on a multi-cell chip simultaneously, the manufacturing processing steps of a plurality of standard cells are complete at this point. The chip therefore comprises a plurality of standard cells having generalized conductive grid patterns associated therewith, and the chip may be stockpiled in this form for subsequent personalization steps as required in any particular design task. Such personalization steps can produce the four-way NOR circuit shown in Fig. 6, and any of a plurality of other circuit designs. Further, the personalization steps may be used to produce logic circuits requiring a plurality of interconnected and contiguous standard cells according to the same techniques, which will be hereinafter described.

Subsequent cell personalization steps involve the selective application of laser cutting devices to the conductor grid pattern shown in Fig. 5A. Commercially available laser cutting devices are capable of directing a laser beam to any position on a chip to an accuracy of plus or minus 1 micron. Such cutting devices can generate an intense heat cutting beam having a cutting width of approximately 2 microns, and can be programmably controlled so as to direct this cutting beam over very short segments at any position on a chip. Since a chip typically has dimensions of about 6.2 millimeters (mm) square, laser cutting devices are commercially available to locate any position on a chip of this size and to perform cuts of several microns in length at any position on the chip. The conductors shown in Fig. 5A are generally several microns in width and conductor-to-conductor spacing is also on the order of several microns. Therefore, commercially available laser technology is adaptable for positioning a laser beam to locate any single conductor segment on the chip, and to perform a laser cutting operation across any single conductor segment.

Commercially available laser welding techniques are also used in connection with the subsequent interconnections between cells, and accuracies are possible to permit a laser welding device to be positioned and directed at any location on the chip and to perform a laser welding operation at that location without affecting conductors adjacent to the point of welding. In the present invention, laser welding techniques are utilized to form a conductive bond between a discrete location on an M1 metal conductor and an M2 metal conductor at the same location. This is accomplished by directing the laser welding beam to a point of intersection of the desired M1 and M2 conductors, actuating the laser welding beam to essentially burn through the upper M2 layer and through the intermediate insulating layer, down to the M1 layer located immediately below the contact point. This laser welding technique will result in a conductive weld being formed between the respective M1 and M2 conductor segments at the location of the laser contact point.

The laser cutting and welding devices described above may be programmably adapted to selectively perform a plurality of cutting and welding operations across the face of the chip so as to perform personalization steps to convert a plurality of standard cells into special circuit designs. The programmable steps may be controlled by a properly programmed computer, so that an entire chip may be personalized during a single cutting and welding operation. The actual time required for such cutting and welding operations is significantly less than the time which otherwise be required for developing special M1 and M2 conductive patterns, and for engaging in the manufacturing process steps necessary for overlaying such M1 and M2 layers on the lower semiconductive substrate.

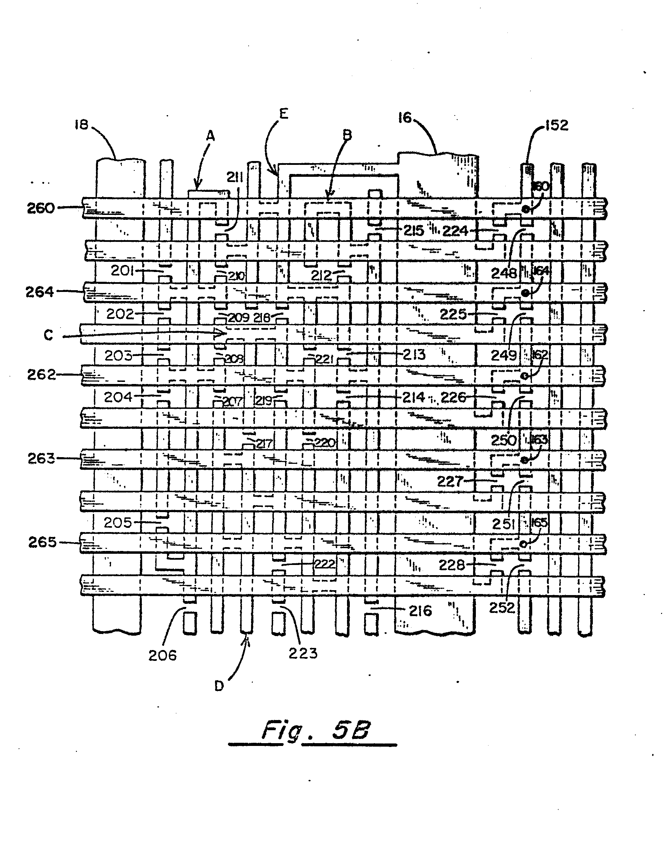

Fig. 5B shows the M1 metal layer of a standard cell after the cell personalization steps summarized above have been accomplished. These personalization steps are required in order to convert the standard cell into the logic circuit shown on Fig. 6. Referring to Fig. 6. Referring to Fig. 5B, and with reference to Fig. 3, the cell personalization step requires that a plurality of laser cuts be made to the M1 overlay pattern of Fig. 3. For example, laser cuts 201-211 are made to create an isolated M1 conductor segment A. Conductor segment A interconnects vias 103, 104, 113 and 117 of the standard cell shown in Fig. 1. Laser cuts 212-216 form a conductor segment B in the M1 metal overlay. Conductor segment B interconnects vias 105, 107, 109, 114, and 118 of the circuit of Fig. 1. Laser cuts 209, 208, 217-221 are made to form conductor segment C, which interconnects vias 111 and 112 in the circuit of Fig. 1. Laser cuts 207, 217, 219, 220, and 222 are made to form conductor segment D, which interconnects vias 115 and 116 in the circuit of Fig. 1. Laser cuts 210, 211, 218, 221, and 213 are made to form conductor segment E, which interconnects vias 108 and 110 in the circuit of Fig. 1. Conductor segments D and E are both circuit ground connections, and any vias which are coupled to these circuit segments are held as circuit ground potential. Laser cuts 224-228 are made to disconnect the circuit ground conductor segment E from the respective output vias 121-125. When all of the laser cuts described above are made, the standard cell circuit of Fig. 1 is reconfigured into a four-way NOR circuit, which is shown in Fig. 6. For purposes of comparison conductor segments A -E are illustrated in Fig. 6, with conductor segments D and E symbolically being shown as connected to circuit ground. It is to be noted that all of the laser cuts illustrated in Fig. 5B are short incremental cuts made across vertical conductor segments, and in all cases are made at points between the respective parallel horizontal conductor segments. In other words, the personalization of a standard cell to from the circuit of Fig. 6 may be accomplished solely by selective laser cutting of conductor segments of the first metal layer M1, with all of the laser cuts required being made in the interspace region between horizontal M2 layer conductors.

The four-way NOR circuit of Fig. 6 has four input terminals 122-125 which may receive signals from other standard cells located on the same chip. Likewise, the NOR circuit of Fig. 6 has a single output terminal 121 which may be connected to another cell on the same chip. These terminals 121-125 are represented as vias 121 -125, which may be found on Fig. 5A at positions located below respective intersecting M1 and M2 conductors. For example, output via 121 is found at location 160 beneath an intersecting M1 and M2 conductor. Similarly input vias 122-125 are each found at locations 162-165 respectively, beneath intersecting M1 and M2 conductors. The external connections to each of these vias may be made by laser welding techniques, wherein a laser weld is made between the intersecting M1 and M2 conductors at the appropriate via locations.

Referring to Fig. 5B, an example of connections to external circuits is shown with respect to the input and output terminals described above. First, M1 conductor 151 (Fig. 5A) is broken into a series of segments by laser cuts 248-252, which serves to provide signal isolation between the respective vias. Next, laser welds are applied at locations 160, and 162-165, to provide a conductive path from the respective vias to an M2 conductor, as shown in Fig. 5B. As a result of these steps, the output signal on via 121 is conductively coupled to M2 conductor 260, where it may be directed to an adjacent or remote cell as circuit design parameters dictate. Similarly, the input signals to vias 122-125 may be coupled to these points from other remote circuits over M2 conductors 262-265 respectively.

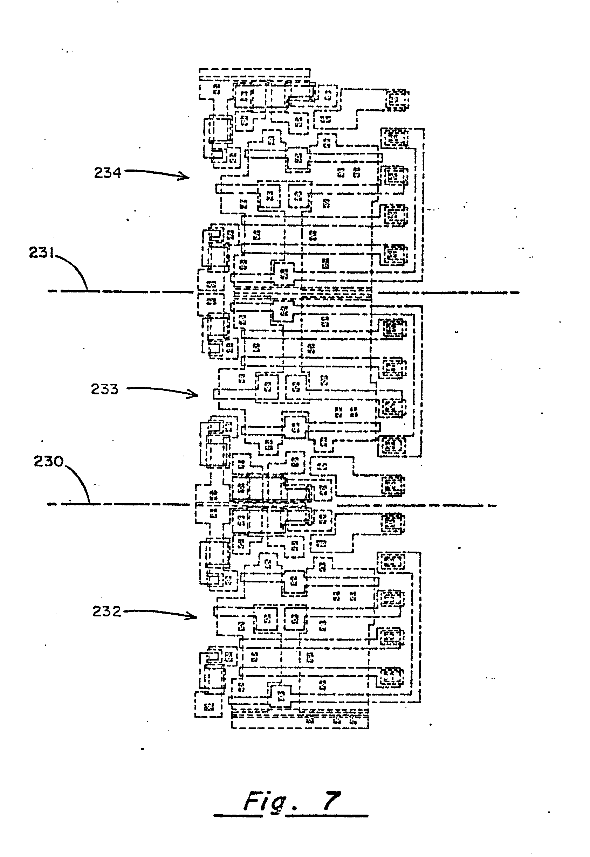

Referring next to Fig. 7, there is shown a portion of a chip having three adjacent standard cells thereon. The standard cells are shown in Fig. 7, separated by respective dotted dividing lines, wherein it is to be noted that any particular standard cell is a mirror image physical representation of its adjacent neighbor. Therefore, the lower standard cell 232 shown on Fig. 7 is a mirror image about dotted line 230 of the center standard cell 233. Likewise, the top standard cell 234 shown in Fig. 7 is a mirror image taken about dotted line 231 of the center standard cell 233. The process steps required for production of a plurality of standard cells laid out as shown in Fig. 7 is the same as has been previously described with reference to Fig. 1, and at the completion of the preliminary process steps each of the standard cells of Fig. 7 has the same properties and physical characteristics as has been described with reference to Fig. 1.

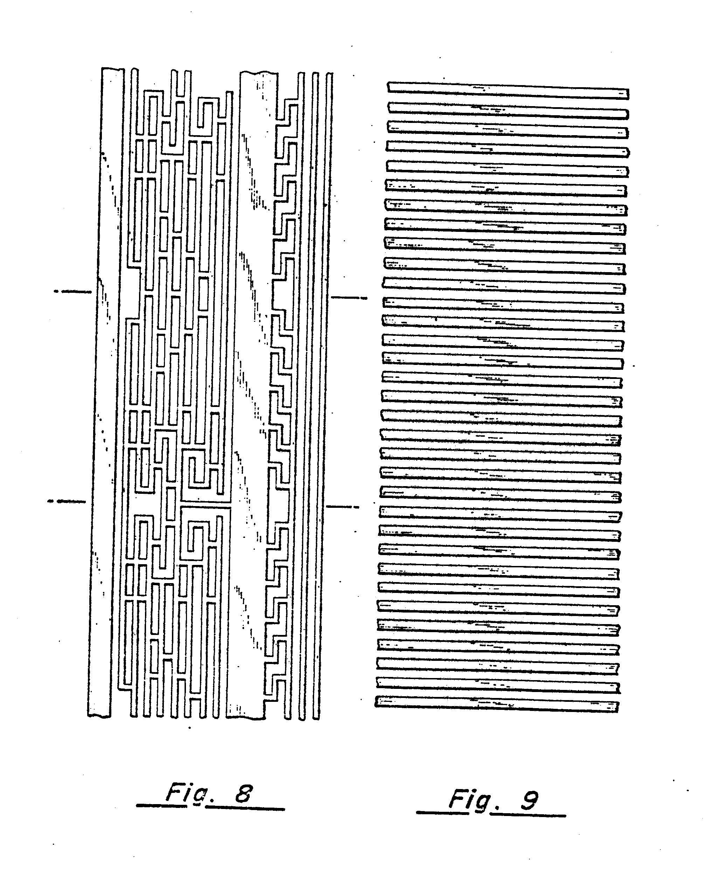

Fig. 8 shows a portion of the M1 metal overlay layer for the plurality of standard cells of Fig. 7. Fig. 9 shows a portion of the M2 metal overlay layer for the same plurality of standard cells. The M1 conductor overlay of Fig. 8, and the M2 conductor overlay of Fig. 9 are each illustrated before any personalization steps have been accomplished, to personalize the standard cell into a particular logic function.

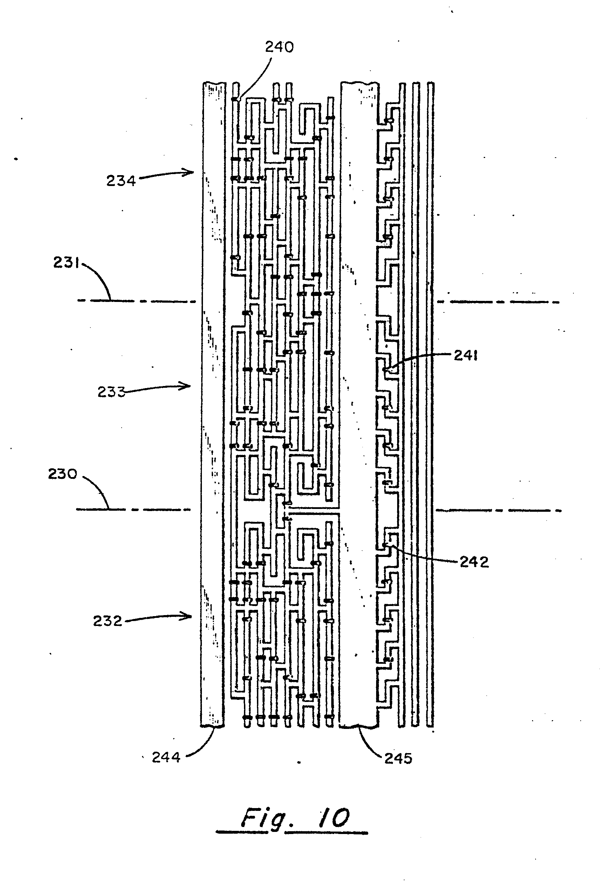

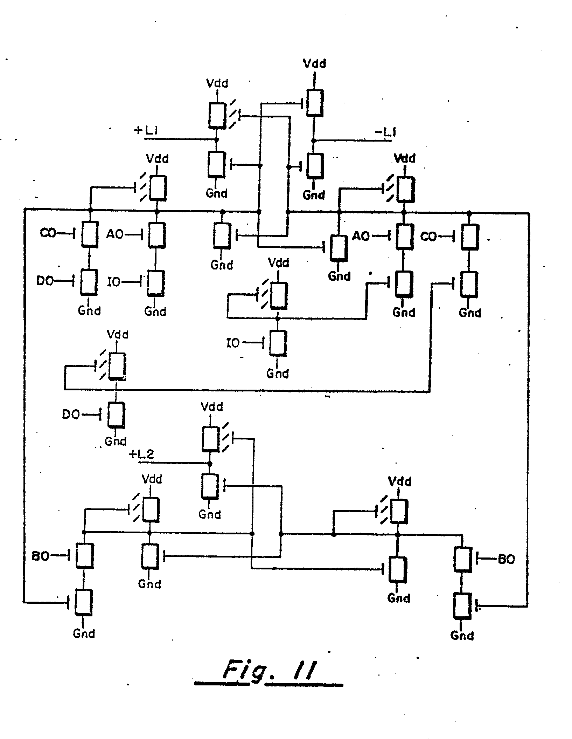

Fig. 10 shows the M1 metal layer of Fig. 8 after personalization steps have been accomplished to create a personalized data shift register latch. The personalized circuit which results from the series of laser cuts shown in Fig. 10 is schematically shown in Fig. 11.

The M1 metal layer of Fig.10 shows thirty-one laser cuts 240 in standard cell 234, twenty-eight laser cuts 241 in standard cell 233, and thirthy-three laser cuts 242 in standard cell 232. The M1 metal overlay in Fig. 10 runs continuously in the vertical direction from cell to cell, thereby providing some degree of intercell conductor segment coupling. For example, conductor segment 244 is a continuous conductor segment extending across all of the standard cells 232, 233, and 234, and is typically used as the power supply bus, which is the source of the power Vdd shown in Fig. 11. Likewise, conductor segment 245 extends over all standard cells and typically forms a ground connection for all circuits within the standard cells, as is shown by the terminals GND in Fig. 11.

The terminals AO-DO and IO represent input signals to the circuit schematic of Fig. 11, and the terminals ± L1 and ± L2 represent output signals. The input signals and the output signals may be coupled into the standard cells of Fig. 10 by means of laser welding connections between the M1 layer and the M2 layer at appropriate locations.

In operation, the method is praticed on a chip which has been premanufactured with a plurality of standard cells and M1 and M2 conductor layers formed thereon. Prior to initiating the method steps each standard cell on the chip will be essentially as represented in Fig. 1, with the M1 and M2 layers as shown in Fig. 5A. For each of the standard cells, or for a plurality of standard cells which are to be interconnected, a procedure is devised which will identify all of the M1 and M2 conductor segments which are to be cut, and the coordinate positions of these cuts are selected. This portion of the process may be facilitated by computer software routines, wherein a library of available logic circuits may be developed and the corresponding laser cuts required forming each of the circuits in the library may be identified by coordinate positions associated with the cells. Such routines are straightforward, and use entirely conventional techniques. Once the laser cutting positions are identified the cip is mounted to a laser cutting machine, having the capability of laser cutting accuracy to within a few microns, and the laser cutting process is initiated to preferably make all laser cuts on a chip during a single operation. As a further step in implementing the process, the coordinate positions required for laser welds, for intercell signal communication, are also identified and a laser welding machine is programmed so as to automatically implement all laser welds during a single series of operations. After the cutting and welding operations have been completed the chip may be protectively covered according to techniques well known in the art, and then may be used in the design circuit configuration. Since the method does not involve any complex deposition and/or etching steps for personalizing circuits it significantly reduces the total process time required for developing personalized chips.

The present invention may be embodied in other specific forms without departing from the spirit or essential attributes thereof, and it is therefore desired that the present embodiment be considered in all respects as illustrative and not restrictive, reference being made to the appended claims rather than to the foregoing description to indicate the scope of the invention.

## Claims

1. An integrated circuit having an array of multi-function cells, each of said cells having a predetermined arrangement of conductive and semiconductive elements and a plurality of conductive vias connected to selected elements and projecting upwardly in a known configuration, characterized in that it comprises

a) an insulating layer overlaying said array and having said conductive vias projecting therethrough;

b) a pattern of M1 metal conductors arranged in generally parallel conductor segments overlaying said insulating layer and conductively coupled to said vias, said M1 conductor pattern being repetitively reprocduced across said array of cells;

c) an insulating layer over said M1 conductor pattern; and

d) a further pattern of M2 metal conductors arranged in parallel conductor segments orthogonal to said M1 conductor pattern, wherein M1 conductor segments bridge the gap between adjacent M2 conductor segments.

2. The integrated circuit of claim 1, characterized in that said M1 conductor pattern further comprises segment branches parallel to said M2 conductor segments in positions directly below said M2 conductor segments.

3. The integrated circuit of claim 2, characterized in that said M1 conductor pattern comprises at least a portion of every M1 conductor segment passing through a vertical plane which does not coincide with an M2 conductor segment.

4. The integrated circuit of claim 3, characterized in that said M1 conductor pattern comprises at least a portion of every M1 conductor segment passing through a vertical plane which coincides with an M2 conductor segment.

5. The integrated circuit of claim 4 characterized in that said parallel M1 conductor segments and said parallel M2 conductor segments are spaced apart at least 2 microns.

6. A method of personalizing functions of an integrated circuit having an array of multi-function cells, wherein each of said cells have a first M1 conductor overlay comprising a pattern of generally parallel conductor segments, and a second M2 conductor overlay comprising a pattern of parallel conductor segments orhtogonal to said M1 pattern, and an insulating layer separating said M1 pattern and said M2 pattern, characterized in that it comprises the steps of

a) identifying the M1 conductor segments necessary for interconnecting elements of each of said integrated circuit cells to achieve the desired personalized functions;

b) identifying the M1 conductor segments necessary for disconnecting elements of each of said integrated circuit cells to achieve the desired personalized functions; and

c) selectively cutting M1 conductor segments by a laser been directed between adjacent M2 conductor segments and through said insulating layer, according to the identified M1 conductor segments of steps a) and b).

7. The method of claim 6, further characterized in that it comprises the steps of

d) identifying the M2 conductor segments necessary for interconnecting elements of said integrated circuit cells to achieve the desired personalized functions;

e) identifying the M2 conductor segments necessary for disconnecting elements of said integrated circuit cells to achieve the desired personalized functions;

f) selectively cutting M2 conductor segments by a laser beam, without also cutting through said insulating layer, according to the identified M2 conductor segments of steps d) and e); and

g) selectively welding M2 conductor segments and M1 conductor segments together, by a laser beam directed at an intersecting point of said M1 and M2 conductor segments, according to the identified M1 conductor segments of steps a) and b) and the identified M2 conductor segments of steps d) and e).

8. The method of claim 7, characterized in that the steps of selectively cutting further comprise cutting a width of approximately two microns.

_Fig. 1_

Fig. 2

*Fig. 3*

_Fig. 4_

Fig. 5A

Fig. 5B

*Fig. 6*

234

231

233

230

232

_Fig. 7_

Fig. 8

Fig. 9

Fig. 10

_Fig. II_

## DOCUMENTS CONSIDERED TO BE RELEVANT

| Category | Citation of document with indication, where appropriate, of relevant passages | Relevant to claim | CLASSIFICATION OF THE APPLICATION (Int. Cl.4) |
|---|---|---|---|
| X | IEEE TRANSACTIONS ON ELECTRON DEVICES, vol. ED-32, no. 2, February 1985, pages 479-486, IEEE, New York, US; J.I. RAFFEL et al.: "A wafer-scale digital integrator using restructurable VSLI" <br> * Figures 4,6; page 479, right-hand column, paragraph 3 - page 481, right-hand column, paragraph 2 * | 1-4,6, 7 | H 01 L 23/52 <br> H 01 L 27/02 |
| A | US-A-4 240 094 (J.M. MADER) <br><br> * Figures 1,3,6; column 2, line 42 - column 3, line 6; claims 1-6,11,18 * | 1-4,6, 7 | |

TECHNICAL FIELDS
SEARCHED (Int. Cl.4)

H 01 L

The present search report has been drawn up for all claims

| Place of search | Date of completion of the search | Examiner |
|---|---|---|
| THE HAGUE | 31-10-1986 | MACHEK, J. |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document